# EUROPÄISCHE PATENTANMELDUNG

(11) **EP 1 270 760 A1**
(43) Veröffentlichungstag der Anmeldung: **02.01.2003**
(21) Anmeldenummer: 02013331.0
(22) Anmeldetag: 18.06.2002
(51) Int. Cl.: C23C 14/04, C23C 14/02

(54) **Sputterverfahren zur Beschichtung von Substraten**

(30) Priorität: 19.06.2001 DE 10129313
(71) Anmelder: FRAUNHOFER-GESELLSCHAFT ZUR FÖRDERUNG DER ANGEWANDTEN FORSCHUNG E.V., 80636 München (DE)
(72) Erfinder: Matthée, Torsten, Dr. Dipl.-Phys., 25582 Hohenaspe (DE); Jung, Thomas, 38173 Hötzum (DE); Klages, Claus-Peter, Dr.Dipl.-Chem., 38102 Braunschweig (DE); Thomas, Michael, Dr. Dipl.-Chem., 31275 Lehrte (DE)
(74) Vertreter: Pfenning, Meinig & Partner GbR

(57) **Zusammenfassung**

Die Erfindung betrifft ein Sputterverfahren zur Beschichtung und Oberflächenbehandlung von Substraten mittels einer strukturierten Elektrodenmaske, die mit Durchbrechungen versehen ist und auf dem Substrat angeordnet wird. Ebenso betrifft die Erfindung eine Vorrichtung zur Beschichtung und Oberflächenbehandlung von Substraten.

## Beschreibung

Für die Metallisierung von spritzgegossenen Schaltungsträgern zur Herstellung von strukturierten Leiterbahnen, die typischerweise auf Kupfer basieren, werden verschiedene Verfahren eingesetzt. Die Schaltungsträger sind typischerweise dreidimensional gestaltete Formteile aus Kunststoff, auf denen ein Leiterbild in Form einer strukturierten Metallschicht aufgebracht ist. Man bezeichnet sie als Molded Interconnect Devices (MID).

Die Kunststoffmetallisierung erfolgt bei den industriell eingesetzten Verfahren zur Laser- und Maskenstrukturierung von MIDs auf chemogalvanischem Weg und beinhaltet die Verfahrensschritte Konditionierung, Aktivierung und chemische Metallabscheidung (Metallisierung). Aufgrund geringer Abscheideraten sind mit dieser Methode meist nur Schichtdicken von 1 µm bis 3 µm möglich. Mittels galvanischer Verstärkung kann diese erste leitfähige Metallschicht auf die gewünschte Schichtdicke verstärkt werden (18 µm bis 35 µm für Elektronikanwendungen). Alternativ zu diesem Verfahren werden besonders beim Zwei-Komponenten-Spritzgießen sogenannte kernkatalytische Kunststoffe eingesetzt, die bereits eine katalytisch wirkende Palladiumverbindung enthalten und somit eine selektive Metallisierung des Kunststoffes ermöglichen. Nachteil dieses Verfahrens ist, daß zwei Spritzgußprozesse erforderlich sind und zur Ausbildung der Leiterbahnen eine selektive galvanische Metallisierung notwendig ist.

Entsprechend der Vorgehensweise bei der Metallisierung unterscheidet man Subtraktiv-, Semiadditiv- und Additivprozeß. Wird zuerst eine Metallschicht über die gesamte Fläche bis zur vollen Schichtstärke abgeschieden und danach strukturiert, spricht man von Subtraktivverfahren. Ein subtraktives Verfahren ist die Laserstrukturierung, bei der nach der vollflächigen Metallisierung ein Ätzresist aufgebracht wird, der mit einem Laser strukturiert wird. Das so freigelegte Kupfer wird weggeätzt und anschließend das Resist entfernt. Neben der hohen Anzahl an Prozeßschritten verlangsamt zusätzlich das nacheinander durchgeführte Schreiben der Strukturen, d.h. die serielle Herstellung, das Verfahren. Zudem sind hohe Investitionskosten erforderlich, da der notwendige Laser und die erforderliche Apparatur zur Substratbewegung teuer sind.

Beim Semiadditivprozeß wird die Leiterstruktur bereits auf der chemisch aufgebauten Metallschicht festgelegt und diese selektiv bis zur gewünschten Schichtdicke verstärkt. Dies kann zum einen durch eine Laserstrukturierung erfolgen. Es gibt aber auch die Möglichkeit der Maskenbelichtung, bei der das chemisch metallisierte Kunststoff-Formteil mit einen Photoresist beschichtet wird und anschließend eine Belichtung mittels UV-Strahlung durch eine dreidimensionale Maske erfolgt. Die nicht belichteten Bereiche des Resists werden entfernt und die freiliegenden Kupferschicht bis zur gewünschten Leiterstärke galvanisch verstärkt. Abschließend erfolgt eine Entfernung des belichteten Photoresists sowie der verbliebenen chemischen Kupferschicht in den Leiterbahn-Zwischenräumen. Bei diesem Prozeß ist es notwendig, daß die Maske im innigen Kontakt mit dem Schaltungsträger steht, um die Belichtung unerwünschter Bereiche zu vermeiden. Auch die ausreichende Belichtung von Schrägen oder Bohrungen ist nur mit einer komplizierten Bewegung des Substrates erforderlich. Beide Nachteile sind noch nicht gelöst worden und stehen der industriellen Einführung des Prozesses im Wege.

Beim Additivprozeß wird ein Haftvermittler oder die Kunststoffoberfläche z.B. mittels eines Lasers direkt strukturiert. Dadurch wird das Metall nur auf den Leiterbereichen abgeschieden. Dafür wurden in den letzten Jahren kostenaufwendige Füllsstoffsysteme entwickelt, die in die Kunststoffe eincompoundiert werden und mittels Laser für die chemische Metallabscheidung aktiviert werden können. Weitere additive Verfahren sind das oben schon erwähnte Zwei-Komponenten-Spritzgießen und das Heißprägeverfahren, bei dem unter Druck und Wärmezufuhr eine Kupferprägefolie mit haftvermittelnder Schicht auf das Substrat gepreßt wird. Durch die Wärmeeinwirkung wird das thermoplastische Substrat an der Oberfläche angeschmolzen bzw. erweicht. Dabei werden die Leiterbahnen aus der Kupferfolie ausgeschert und mit dem Substrat verbunden. Nachteil des Heißprägeverfahrens ist die nur bedingte Einsatzmöglichkeit für dreidimensionale Bauteile und die geringe Eignung für den Bereich EMV-Abschirmung.

Eine weitere Möglichkeit zur Metallisierung von Kunststoff-Bauteilen stellt die Beschichtung im Vakuum dar. Nach der Aktivierung durch einen Plasmaprozeß wird mittels eines PVD-Verfahrens (Physical Vapour Deposition) durch Bedampfen oder Sputtern im Vakuum in der Regel Schichtdicken von einigen 100 nm bis zu einigen µm erzeugt, die für die MID-Anwendungen wiederum galvanisch verstärkt werden können. Beispiele für diese Verfahren sind z.B. das Magnetronsputtern, das plasmaaktivierte Bedampfen, die Vakuumbogenbeschichtung und das Hochfrequenz-CVD-Verfahren. Diese Verfahren haben jedoch den Nachteil, daß der apparative Aufwand für die notwendige Hoch- oder Feinvakuumerzeugung hoch ist und zur Behandlungsdauer die Zeiten für die Evakuierung und Belüftung der Apparatur hinzukommen.

Im Bereich der Hochrateverfahren ist insbesondere das Hohlkathodensputtern für die ganzflächige Beschichtung hervorzuheben (DE 105 05 268 A1). Neben dem Sputtern von Metallen ist durch die Zufuhr von Reaktivgasen (z.B. O₂ oder N₃) im Bereich zwischen der Hohlkathode und dem zu beschichtenden Substrat die Herstellung von Oxiden und Nitriden möglich. Durch CVD-Prozesse ist ebenfalls eine Modifikation und Funktionalisierung möglich. Ein Inertgasstrom transportiert das Material zum zu beschichtenden Substrat und unterdrückt die Beschichtung der Hohlkathode. Die Nachteile dieses Verfahrens liegen zum einen im hohen Verbrauch an Inertgas für die Reaktivgasverdrängung.

Weiterhin sind sehr große Vakuumpumpen erforderlich, um das Inertgas abzupumpen. Außerdem geht ein großer Teil der Plasmaenergie verloren, da das Reaktivgas nicht in die Zone mit der größten Plasmaintensität gelangt. Das Verfahren kann nur kurzzeitig oder mit sehr geringer Leistung eingesetzt werden, sonst ist ein kostenaufwendiger Aufbau zur Wasserkühlung notwendig.

Auch die Verwendung von Masken zur Strukturierung (DE 197 55 902 C1) bzw. zur Großflächenbeschichtung (H. Koch et al., J. Vac. Sci. Tech A9 (1991) 2374) ist aus dem Stand der Technik bekannt.

Die Durchführung von plasmagestützten CVD-Prozessen ermöglicht eine Modifikation und Funktionalisierung der Schichtoberfläche. Durch eine gezielte Modifikation einer Kunststoffoberfläche ist es möglich,z.B. die Haftfestigkeit (Ti bei PTFE) zu erhöhen.

Aber auch die Einstellung von hydrophoben und hydrophilen Eigenschaften an der Oberfläche ist bekannt. Eine strukturierte Funktionalisierung ist mit Atmosphärendruck-Plasmaverfahren durchgeführt worden (DE 100 56 564). Hier wird eine strukturierte Metalloder Keramikmaske auf das Substrat gepreßt und eine Barriereentladung im Hohlraum gezündet. Die Nachteile dieses Verfahrens sind zum einen der hohe Gasverbrauch, da bei Drücken von 10⁴ bis 10⁶ Pa gearbeitet wird. Außerdem besteht nicht die Möglichkeit, Metalle zu sputtern, so daß ein kombiniertes Verfahren nicht möglich ist, und die Anwendung ist auf ebene Substrate beschränkt. Auch sind die Ionenenergien dieses Verfahrens geringer als bei dem Hohlkathodenverfahren. Mit höheren Ionenenergien ist eine bessere Haftfestigkeit der Schichten gewährleistet, und man erhält glattere Schichten.

Aufgabe der Erfindung war es daher, die oben genannten Nachteile der bekannten Verfahren zur Beschichtung von Substraten zu beheben und ein Verfahren zur Verfügung zu stellen, bei dem mittels einer Elektrodenmaske eine kompliziert strukturierte Aktivierung, Bekeimung, Metallisierung und/oder Funktionalisierung von dreidimensionalen Kunststoffteilen ermöglicht wird.

Erfindungsgemäß wird ein Sputterverfahren zur Beschichtung und/oder Oberflächenbehandlung von Substraten mittels einer strukturierten Elektrodenmaske bereitgestellt. Die Elektrodenmaske ist dabei mit Durchbrechungen versehen und wird direkt auf dem Substrat angeordnet. Das Verfahren umfaßt dabei folgende Schritte:
a) eine Aktivierung der Substratoberfläche in den von der Elektrodenmaske freigelassenen Bereichen durch Zündung eines Volumenplasmas bei einem Prozeßdruck zwischen 1 und 70 Pa. Die Dauer der Aktivierung liegt dabei je nach Substrat im Bereich weniger Sekunden (5 bis 10 s) bis zu mehreren Minuten (5 min).
b) Eine beschichtete Substratoberfläche in den von der Elektrodenmaske freigelassenen Bereichen durch Zündung von Hohlkathoden-Plasmaentladungen in den Durchbrechungen bei einem Prozeßdruck zwischen 70 und 500 Pa. Die Beschichtungsdauer liegt hierbei je nach Schichtdicke und Material der Elektrodenmaske zwischen wenigen Sekunden (5 bis 10 s) und mehreren Minuten(5 min).

Ein besonderer Vorteil dieses Verfahrens ist es, daß die eingesetzten Elektrodenmasken sowohl zur Plasmaaktivierung als auch zur Beschichtung des Substrates eingesetzt werden können. Die strukturierte Elektrodenmaske wird auf das Substrat gelegt, so daß eine präzise Abbildung der Struktur ermöglicht wird. Im Aktivierungsschritt a) kommt es dabei durch Zündung eines Volumenplasmas bei dem angegebenen Prozeßdruck zu einer Aktivierung des Substrates an den freiliegenden Oberflächen. Im zweiten Schritt wird dann der Prozeßdruck auf Werte zwischen 70 und 500 Pa erhöht. Dadurch kommt es in den Durchbrechungen zum Zünden von sogenannten Hohlkathoden-Glimmentladungen, die ein etwa tausendfach intensiveres Plasma erzeugen. Da die Verwendung der gleichen Elektrodenmasken möglich ist, können auch sämtliche Verfahrensschritte dadurch in einem einzigen Plasmareaktor durchgeführt werden.

Die Elektrodenmaske schattet bei der Aktivierung die nicht relevanten Bereiche ab, so daß es zu einer selektiven Aktivierung der gewünschten Leiterbahnstrukturen kommt. Die für die Aktivierung der Oberfläche benötigten Ionen aus dem Plasma können durch die elektrische Kontaktierung der Elektrodenmaske auf die gewünschten Bereiche gelenkt werden. An die Elektrodenmaske kann nun eine Spannung zwischen -5 und +5 kV angelegt werden, wodurch die Plasmaionen entweder angezogen oder abgestoßen werden.

Die Elektrodenmaske dient bei der Beschichtung als Materialquelle. In Abhängigkeit von der elektrischen Leistung und dem Prozeßdruck im Plasmareaktor ist es möglich, in unterschiedlichen Durchbrechungsbreiten Hohlkathoden zu zünden. Sind die Durchbrechungen beispielsweise als Spalten ausgestaltet, so können die Spaltbreiten in einem Bereich zwischen 100 µm und 5 mm liegen.

In einer bevorzugten Ausführungsform wird die Aktivierung der Substratoberfläche bei einem Prozeßdruck zwischen 1 und 50 Pa durchgeführt, während die Beschichtung der Substratoberfläche in Schritt b) bei einem Prozeßdruck zwischen 100 und 400 Pa bevorzugt ist.

Bevorzugt erfolgt die Beschichtung der Substratoberfläche mit Metalloxiden oder Metallen. Hierzu zählen beispielsweise Kupfer oder Platin, die bei der Ausbildung von Leiterstrukturen besondere Bedeutung haben.

Bei einer bevorzugten Ausführungsform wird vor der Beschichtung des Substrates eine Bekeimung der aktivierten Substratoberfläche zur Haftverbesserung durchgeführt. Hierbei wird als Bekeimungsmaterial bevorzugt Titan verwendet, was sich besonders bei der Bekeimung von schlecht haftenden metallisierbaren Kunststoffen anbietet.

In einer weiteren Alternative des erfindungsgemäßen Verfahrens wird nach der Beschichtung in einem zusätzlichen Schritt c) eine Funktionalisierung der beschichteten Substratoberfläche durch Zuleitung von mindestens einem Precursor durchgeführt. Dadurch erhält die Metallisierung eine funktionelle Oberfläche. Hierbei können sowohl hydrophobe bzw. hydrophile Precursor eine Rolle spielen. Ebenso ist es aber auch denkbar, daß dadurch das Eigenschaftsprofil der Substrate hinsichtlich Kratzschutz oder Durchschlagsfestigkeit verbessert wird.

Bevorzugt wird die Funktionalisierung mit Si-, NH- und/oder Ti-haltigen Precursorn, z.B. HMDSO, TMS, Allylamin oder Ti-Isopropylat, durchgeführt.

Die an der Elektrodenmaske angelegte Spannung kann bei dem erfindungsgemäßen Verfahren zwischen -5 und +5 kV liegen. Dabei ist es möglich, daß für sämtliche Verfahrensschritte die gleiche Elektrodenmaske verwendet wird; ebenso ist es aber auch möglich, daß für die einzelnen Schritte unterschiedliche Elektrodenmasken verwendet werden, z.B. durch unterschiedliche Strukturierungen.

In einer weiteren Alternative des Verfahrens kann die Zündung der Hohlkathoden-Glimmentladung durch eine zusätzliche Hilfselektrode unterstützt werden. An diese Hilfselektrode kann eine Spannung im Bereich zwischen -5 und +5 kV angelegt werden. Dabei können Elektrodenmaske und Hilfselektrode sowohl auf gleicher Spannung als auch auf unterschiedlicher Spannung liegen.

Erfindungsgemäß wird ebenso eine Vorrichtung zur Beschichtung und/oder Oberflächenbehandlung von Substraten bereitgestellt, wobei das Substrat in einer Vakuumkammer angeordnet ist und die Vorrichtung einer strukturierte Elektrodenmaske mit mindestens einer Durchbrechung aufweist.

Bevorzugt weist die strukturierte Elektrodenmaske spaltförmige Durchbrechungen mit einer Spaltbreite zwischen 100 µm und 5 mm auf. Als Material für die Elektrodenmaske wird bevorzugt ein Metalloxid oder Metall, wie z.B. Kupfer oder Platin verwendet. Vorzugsweise weist die Vorrichtung eine zusätzliche Hilfselektrode auf, die als Zündhilfe für die Hohlkathoden-Glimmentladung Verwendung findet. Diese Hilfselektroden können sowohl aus dem gleichen Material als auch aus unterschiedlichem Material wie die Elektrodenmaske bestehen. Die Hilfselektrode ist dabei bevorzugt mit 3 bis 10 mm zur Elektrodenmaske beabstandet. Alternativ kann die Elektrodenmaske auch als zylindrischer Mantel ausgebildet sein, wobei die Elektrodenmaske dann eine als Stab ausgebildete Hilfselektrode umschließt. Hierdurch wird ermöglicht, daß als Substrate z.B. Folien verwendet werden können, wobei die Folie dann an dem drehbaren zylindrischen Mantel entlanggeführt wird und dadurch eine Aktivierung, eine Beschichtung oder auch eine Funktionalisierung der Oberfläche erfolgen kann. Dies kann beispielsweise mit einer einzigen Vorrichtung erfolgen, ebenso ist es aber auch möglich, daß für jeden einzelnen Verfahrensschritt a), b), c) eine eigene Vorrichtung verwendet wird.

Anhand der folgenden Figuren und Beispiele soll der erfindungsgemäße Gegenstand näher erläutert werden, ohne ihn dadurch auf diese zu beschränken.

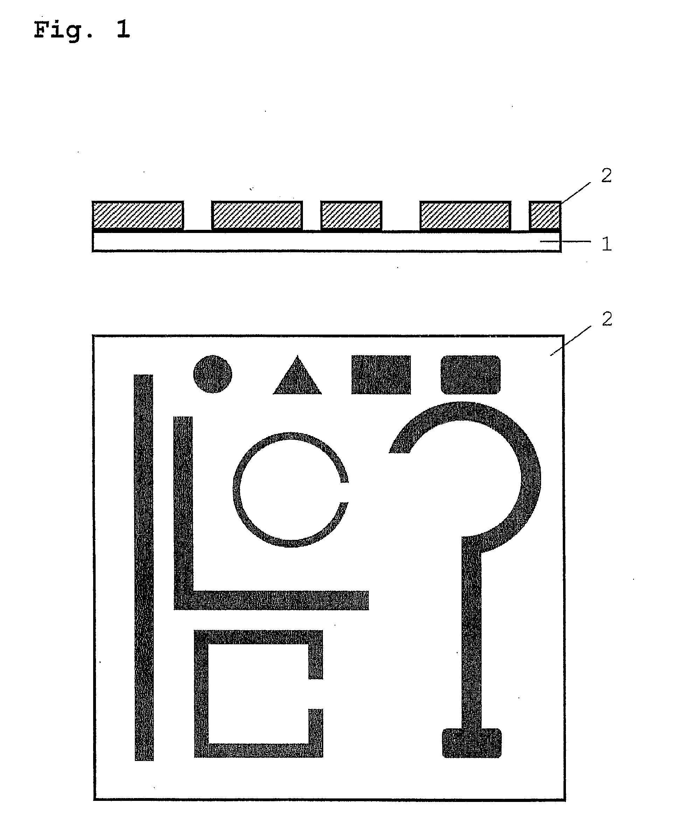

- Fig. 1: zeigt eine erfindungsgemäße Anordnung der Elektrodenmaske 2 auf dem Substrat 1. An die Elektrodenmaske wird dabei eine Spannung angelegt. Ebenso werden in Fig. 1 für die Elektrodenmaske beispielhafte Strukturierung aufgezeigt. Diese können beliebige geometrische Formen darstellen. Hierzu zählen Quadrate, Kreise, Dreiecke, Schlitze und andere kanalförmige Strukturen. Die Breite der Strukturierung kann dabei zwischen 100 µm und 5 mm variieren.

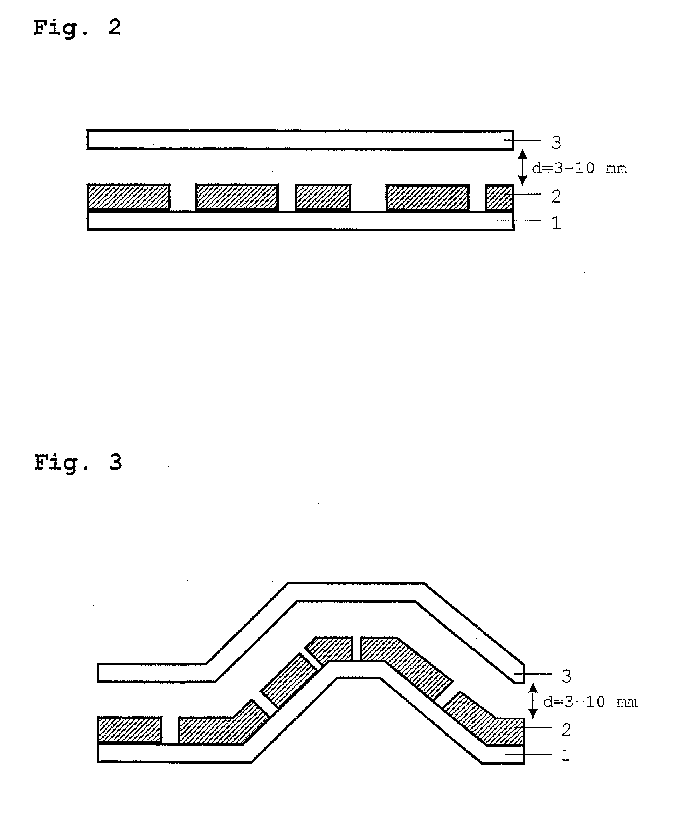

- Fig. 2: zeigt den erfindungsgemäßen Aufbau bei Verwendung einer zusätzlichen Hilfselektrode 3. An diese wird eine Spannung angelegt, die sich von der an der Elektrodenmaske 2 anliegenden Spannung unterscheidet. Ebenso ist es aber auch möglich, daß beide auf gleicher Spannung liegen. Der Abstand zwischen der Elektrodenmaske 2 und der Hilfselektrode 3 beträgt zwischen 3 und 10 mm. Dagegen ist die Elektrodenmaske 2 direkt auf dem Substrat 1 angeordnet.
- Fig. 3: zeigt einen zu dem in Fig. 2 vergleichbaren Aufbau, wobei in diesem Fall das Substrat 1 eine dreidimensionale Oberflächenstrukturierung aufweist. In diesem Fall wird die Elektrodenmaske 2 exakt der Oberflächenstruktur des Substrates nachempfunden, so daß die Elektrodenmaske formschlüssig auf das Substrat 1 aufgesetzt werden kann. Zusätzlich wird hier die Hilfselektrode 3 ebenfalls gleichförmig ausgestaltet und in einem Abstand zwischen 3 und 10 mm von der Elektrodenmaske 2 angeordnet. An Hilfselektrode 3 und Elektrodenmaske 2 liegen hierbei unterschiedliche Spannungen an. Ebenso ist es aber auch möglich, daß beide auf gleicher Spannung liegen.

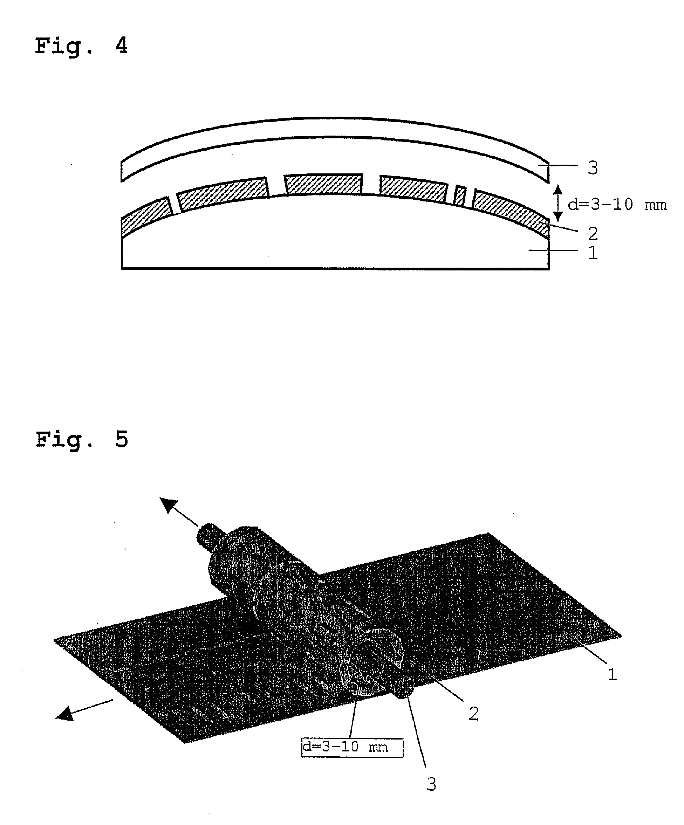

- Fig. 4: zeigt analog zu Fig. 3 die Durchführung des Sputterverfahrens bei einem Substrat mit dreidimensionaler Oberflächenstruktur, in diesem Fall einer kuppelförmigen Substratoberfläche.
- Fig. 5: stellt den Aufbau für die Beschichtung einer Folie mit dem Sputterverfahren dar. Hierbei stellt die Elektrodenmaske 2 einen zylindrischen Mantel dar, der in der Bewegungsrichtung der Folien rotieren kann. Im Zentrum des zylindrischen Mantels ist eine Hilfselektrode 3 angeordnet, die als Stab ausgebildet ist. An der Elektrodenmaske 2 und der Hilfselektrode 3 liegen auch hier wieder unterschiedliche Spannungen an. Die Beschichtung der Folie kann nun dadurch erfolgen, daß die Folie an der als zylindrischem Mantel ausgestalteten Elektrodenmaske entlang geführt wird. Ebenso ist es aber auch möglich, daß die Folie eingespannt ist und sich die Elektrodenmaske und die Hilfselektrode bewegen, d.h. rotieren.

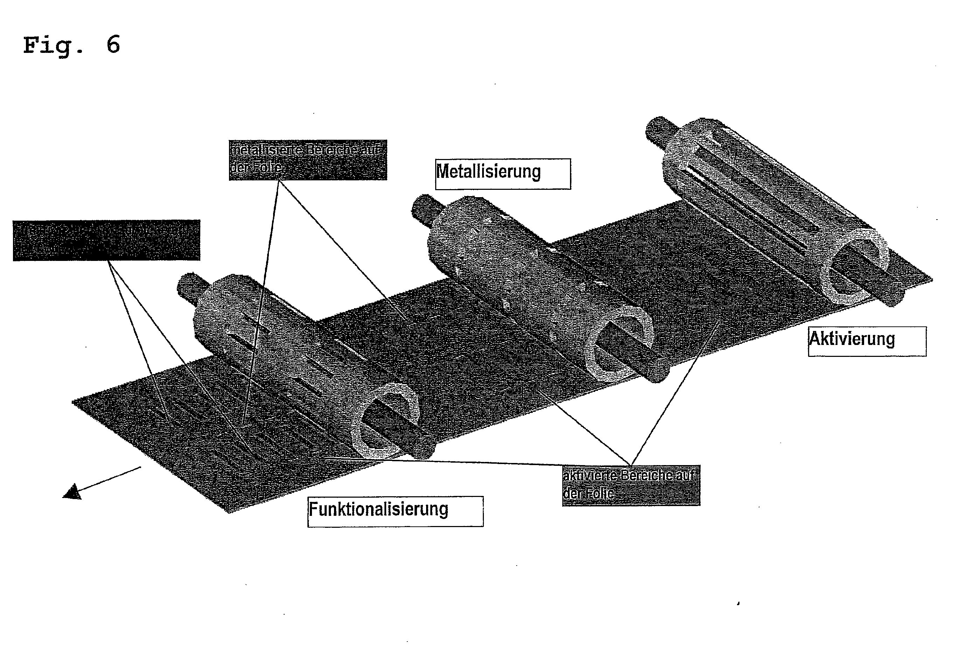

- Fig. 6: zeigt in Anknüpfung an Fig. 5, die Durchführung eines Folienbeschichtungsverfahrens. Hierbei werden drei verschiedene Elektrodenmasken verwendet. Die erste Maske wird zur Aktivierung verwendet, die zweite Maske für die Metallisierung und die dritte Maske für die Funktionalisierung. In Analogie zur Durchführung, wie es in Fig. 5 beschrieben ist, werden hierbei nun alle drei Verfahrensschritte in einem komplexen System durchgeführt.

### Beispiel 1:

Elektrodenmaske und Hilfselektrode aus dem gleichen Material
a) Aktivierung der Oberfläche in den von der Elektrodenmaske freigelassenen Bereichen mittels Ar-, O₂- oder Ar/O₂-Plasma im Druckbereich zwischen 1 und 50 Pa.
b) Metallisierung der Oberfläche mit z.B. Kupfer, Platin, Titan in den von der Elektrodenmaske freigelassenen Bereichen mittels Hohlkathoden-Plasmaentladung in den Durchbrechungen mittels Ar-Plasma im Druckbereich zwischen 100 und 500 Pa.

### Beispiel 2:

Elektrodenmaske und Hilfselektrode aus dem gleichen Material
a) Aktivierung der Oberfläche in den von der Elektrodenmaske freigelassenen Bereichen mittels Ar-, O₂- oder Ar/O₂-Plasma im Druckbereich zwischen 1 und 50 Pa.
b) Reaktive Beschichtung (Herstellung von Oxiden und Nitriden) der Oberfläche mit z.B. Kupfer, Aluminium, Titan in den von der Elektrodenmaske freigelassenen Bereichen mittels Hohlkathode-Plasmaentladung in den Durchbrechungen mittels O₂-, Ar/O₂-,N₂- oder Ar/N₂-Plasma im Druckbereich zwischen 100 und 500 Pa.

### Beispiel 3:

Elektrodenmaske und Hilfselektrode aus unterschiedlichem Material
**a)** Aktivierung der Oberfläche in den von der Elektrodenmaske freigelassenen Bereichen mittels Ar-, O₂- oder Ar/O₂-Plasma im Druckbereich zwischen 1 und 50 Pa.
**b)** Beschichtung der Oberfläche mit z.B. Aluminium und Titan (Hilfselektrode Titan und Elektrodenmaske Aluminium) in den von der Elektrodenmaske freigelassenen Bereichen mittels Hohlkathoden-Plasmaentladung in den Durchbrechungen mittels O₂-, Ar/O₂-,N₂- oder Ar/N₂-Plasma im Druckbereich zwischen 100 und 500 Pa. Stufenlose Variation der Spannung zwischen Hilfselektrode und Elektrodenmaske im Bereich 0 bis 5 kV ist möglich.

| | |
|---|---|
| Hilfselektrode | Elektrodenmaske |
| 5 kV | 0 kV |
| 5 kV | 5 kV |
| 0 kV | 5 kV |

c) Möglichkeiten:
Herstellung von Legierungsschichten
Herstellung von Gradientenschichten
Herstellung von Multilagenschichten

### Beispiel 4:

Elektrodenmaske und Hilfselektrode aus unterschiedlichem Material
a) Aktivierung der Oberfläche in den von der Elektrodenmaske freigelassenen Bereichen mittels Ar-, O₂- oder Ar/O₂-Plasma im Druckbereich zwischen 1 und 50 Pa.
b) Reaktive Beschichtung der Oberfläche mit z.B. Aluminium und Titan (Hilfselektrode Titan und Elektrodenmaske Aluminium) in den von der Elektrodenmaske freigelassenen Bereichen mittels Hohlkathoden-Plasmaentladung in den Durchbrechungen mittels O₂-, Ar/O₂-, N₂- oder Ar/N₂-Plasma im Druckbereich zwischen 100 und 500 Pa. Stufenlose Variation der Spannung zwischen Hilfselektrode und Elektrodenmaske im Bereich 0 bis 5 kV ist möglich.

| | |
|---|---|
| Hilfselektrode | Elektrodenmaske |
| 5 kV | 0 kV |
| 5 kV | 5 kV |
| 0 kV | 5 kV |

c) Möglichkeiten:
Herstellung von Legierungsschichten
Herstellung von Gradientenschichten
Herstellung von Multilagenschichten

### Beispiel 5:

Elektrodenmaske und Hilfselektrode aus unterschiedlichem Material
a) Aktivierung der Oberfläche in den von der Elektrodenmaske freigelassenen Bereichen mittels Ar-, O₂- oder Ar/O₂-Plasma im Druckbereich zwischen 1 und 50 Pa.
b) Bekeimung der Oberfläche mit z.B. Titan als Elektrodenmaske in den von der Elektrodenmaske freigelassenen Bereichen mittels Hohlkathoden-Plasmaentladung in den Durchbrechungen mittels Ar-Plasma im Druckbereich zwischen 100 und 500 Pa. Spannung Elektrodenmaske (0-5 kV), Spannung Hilfselektrode (0 kV)
c) Metallisierung der Oberfläche mit z.B. Kupfer oder Platin als Hilfselektrode in den von der Elektrodenmaske freigelassenen Bereichen mittels Hohlkathoden-Plasmaentladung in den Durchbrechungen mittels Ar-Plasma im Druckbereich zwischen 100 und 500 Pa.
   Spannung Elektrodenmaske (0 kV),
   Spannung Hilfselektrode (0-5 kV).

### Beispiel 6:

Zwei verschiedene Elektrodenmasken und Hilfselektroden aus gleichem Material
a) Aktivierung der Oberfläche in den von der Elektrodenmaske freigelassenen Bereichen mittels Ar-, O₂- oder Ar/O₂-Plasma im Druckbereich zwischen 1 und 50 Pa.
b) Bekeimung der Oberfläche mit z.B. Titan als Elektrodenmaske (I) in den der Elektrodenmaske freigelassenen Bereichen mittels Hohlkathoden-Plasmaentladung in den Durchbrechungen mittels Ar-Plasma im Druckbereich zwischen 100 und 500 Pa. Spannung Elektrodenmaske (0-5 kV), Spannung Hilfselektrode (0-5 kV).
c) Austausch der Elektrodenmaske und Hilfselektrode:
   Metallisierung der Oberfläche mit z.B. Kupfer oder Platin als Elektrodenmaske (II) in den von der Elektrodenmaske freigelassenen Bereichen mittels Hohlkathoden-Plasmaentladung in den Durchbrechungen mittels Ar-Plasma im Druckbereich zwischen 100 und 500 Pa.
   Spannung Elektrodenmaske (0-5 kV),
   Spannung Hilfselektrode (0-5 kV).

### Beispiel 7:

Funktionalisierung der Oberflächen
a) Im Anschluß an jeden Schritt a), b) oder c) kann eine Funktionalisierung der Oberfläche vorgenommen werden. Durch Zugabe von Si-, NH-, Ti-haltigen Precursorn, z.B. HMDSO, TMS, Allylamin, Ti-Isopropylat können Schichten mit folgenden Eigenschaften erzeugt werden: Kratzschutz, Durchschlagsfestigkeit, hydrophobe bzw. hydrophile Oberflächen, Antihafteigenschaften. Zusammen mit den Precursorn werden Ar-, O₂-, N₂- Plasmen bzw. Gemische dieser Gase erzeugt, um die gewünschten Schichteigenschaften einzustellen. Druckbereich dabei zwischen 1 und 500 Pa.

## Patentansprüche

1. Sputterverfahren zur Beschichtung und/oder Oberflächenbehandlung von Substraten mittels einer strukturierten Elektrodenmaske, die mit Durchbrechungen versehen ist und auf dem Substrat angeordnet wird, mit folgenden Schritten:
a) Aktivierung der Substratoberfläche in den von der Elektrodenmaske freigelassenen Bereichen durch Zündung eines Volumenplasmas bei einem Prozeßdruck zwischen 1 und 70 Pa,
b) Beschichtung der Substratoberfläche in den von der Elektrodenmaske freigelassenen Bereichen durch Zündung von Hohlkathodenplasmaentladungen in den Durchbrechungen bei einem Prozeßdruck zwischen 70 und 500 Pa.

2. Verfahren nach Anspruch 1,
**dadurch gekennzeichnet, daß** in Schritt a) der Prozeßdruck zwischen 1 und 50 Pa liegt.

3. Verfahren nach mindestens einem der vorhergehenden Ansprüche ,
**dadurch gekennzeichnet, daß** in Schritt b) der Prozeßdruck zwischen 100 und 400 Pa liegt.

4. Verfahren nach mindestens einem der vorhergehenden Ansprüche ,
**dadurch gekennzeichnet, daß** in Schritt b) die Beschichtung mit Metalloxiden oder Metallen, z.B. Kupfer und Platin, erfolgt.

5. Verfahren nach mindestens einem der vorhergehenden Ansprüche,
**dadurch gekennzeichnet, daß** vor Schritt b) eine Bekeimung der aktivierten Substratoberfläche zur Haftverbesserung durchgeführt wird.

6. Verfahren nach dem vorhergehenden Anspruch,
**dadurch gekennzeichnet, daß** die Bekeimung der Substratoberfläche mit Titan erfolgt.

7. Verfahren nach mindestens einem der vorhergehenden Ansprüche,
**dadurch gekennzeichnet, daß** nach der Beschichtung in einem weiteren Schritt c) eine Funktionalisierung der beschichteten Substratoberfläche durch Zuleitung von mindestens einem Precursor durchgeführt wird.

8. Verfahren nach dem vorhergehenden Anspruch,
**dadurch gekennzeichnet, daß** die Funktionalisierung mit Si-, NH- und/oder Ti-haltigen Precursorn, z.B. HMDSO,TMS, Allylamin oder Ti-Isopropylat, durchgeführt wird.

9. Verfahren nach mindestens einem der vorhergehenden Ansprüche,
**dadurch gekennzeichnet, daß** an der Elektrodenmaske eine Spannung im Bereich zwischen -5 und +5 kV anliegt.

10. Verfahren nach mindestens einem der vorhergehenden Ansprüche,
**dadurch gekennzeichnet, daß** für die einzelnen Verfahrensschritte die gleiche Elektrodenmaske verwendet wird.

11. Verfahren nach mindestens einem der vorhergehenden Ansprüche,
**dadurch gekennzeichnet, daß** für die einzelnen Verfahrensschritte unterschiedliche Elektrodenmasken verwendet werden.

12. Verfahren nach mindestens einem der vorhergehenden Ansprüche,
**dadurch gekennzeichnet, daß** die Zündung der Hohlkathoden-Glimmentladungen durch eine zusätzlichen Hilfselektrode erleichtert wird.

13. Verfahren nach mindestens einem der vorhergehenden Ansprüche,
**dadurch gekennzeichnet, daß** an die Hilfselektrode eine Spannung zwischen -5 und +5 kV angelegt wird.

14. Vorrichtung zur Beschichtung und/oder Oberflächenbehandlung von Substraten, wobei das Substrat in einer Vakuumkammer angeordnet ist und die Vorrichtung eine strukturierte Elektrodenmaske mit mindestens einer Durchbrechung aufweist.

15. Vorrichtung nach Anspruch 11,
**dadurch gekennzeichnet, daß** die strukturierte Elektrodenmaske spaltförmige Durchbrechungen mit einer Spaltbreite zwischen 100 µm und 5 mm aufweist.

16. Vorrichtung nach mindestens einem der Ansprüche 11 oder 12,
**dadurch gekennzeichnet, daß** die strukturierte Elektrodenmaske aus Metall und/oder Metalloxid besteht.

17. Vorrichtung nach mindestens einem der Ansprüche 11 bis 13,
**dadurch gekennzeichnet, daß** die Vorrichtung eine zusätzliche Hilfselektrode als Zündhilfe für die Hohlkathoden-Glimmentladung aufweist.

18. Vorrichtung nach Anspruch 14,
**dadurch gekennzeichnet, daß** die Hilfselektrode aus dem gleichen Material wie die Elektrodenmaske besteht.

19. Vorrichtung nach Anspruch 14,
**dadurch gekennzeichnet, daß** die Hilfselektrode und die Elektrodenmaske aus unterschiedlichen Materialien bestehen.

20. Vorrichtung nach mindestens einem der Ansprüche 14 bis 16,
**dadurch gekennzeichnet, daß** die Hilfselektrode zur Elektrodenmaske mit 3 bis 10 mm beabstandet ist.

21. Vorrichtung nach mindestens einem der Ansprüche 11 bis 17,
**dadurch gekennzeichnet, daß** die Elektrodenmaske als zylindrischer Mantel ausgebildet ist, wobei die Elektrodenmaske die als Stab ausgebildete Hilfselektrode umschließt.
